# EUROPÄISCHE PATENTSCHRIFT

(11) **EP 4 059 039 B1**
(45) Veröffentlichungstag und Bekanntmachung des Hinweises auf die Patenterteilung: **07.08.2024**
(21) Anmeldenummer: 20803820.8
(22) Anmeldetag: 09.11.2020
(51) Int. Cl.: H01J 37/32, C23C 16/04, C23C 16/455, C23C 16/56

(54) **VORRICHTUNG UND VERFAHREN ZUR PLASMABEHANDLUNG VON BEHÄLTERN**
DEVICE AND METHOD FOR PLASMA TREATMENT OF CONTAINERS
DISPOSITIF ET PROCEDE DE TRAITEMENT AU PLASMA DE CONTENEURS

(30) Priorität: 11.11.2019 DE 102019130303
(43) Veröffentlichungstag der Anmeldung: 21.09.2022
(73) Patentinhaber: KHS GmbH, 44143 Dortmund (DE)
(72) Erfinder: VOGELSANG, Andreas, 22145 Hamburg (DE); HERBORT, Michael, 20535 Hamburg (DE); LENGEFELD, Jan, 24620 Bönebüttel (DE)
(74) Vertreter: Eisenführ Speiser
(86) Internationale Anmeldenummer: PCT/EP2020/081486
(87) Internationale Veröffentlichungsnummer: WO 2021/094252

(56) Entgegenhaltungen:
- WO-A1-2017/162509
- WO-A2-03/100120
- DE-A1- 102015 121 773

## Beschreibung

Die Erfindung betrifft eine Vorrichtung zur Plasmabehandlung von Behältern mit den Merkmalen des Oberbegriffs des Anspruchs 1. Außerdem betrifft die Erfindung ein Verfahren zur Plasmabehandlung von Behältern mit den Merkmalen des Oberbegriffs des Anspruchs 8.

Eine derartige Vorrichtung und ein derartiges Verfahren sind beispielsweise aus der WO 2017/102280 A2 und der WO 03/100120 A2 bekannt.

Im Prozessgaserzeuger der WO 2017/102280 A2 werden die Prozessgasmischungen aus O₂, Ar, HMDSO (Hexamethyldisiloxan) und HMDSN (Hexamethyldisilazan) gemischt. Das bereitgestellte Prozessgas wird mittels Massenflussreglern aus der Gasphase dosiert und aufgrund des Unterdrucks des Vakuumsystems durch die Beschichtungsstationen gesaugt. In den Beschichtungsstationen wird das Prozessgas umgesetzt, um eine Barriereschicht in den Flaschen zu erzeugen. Die Druckverhältnisse im System werden von mehreren Parametern bestimmt: Gasfluss, Saugvermögen der Vakuumpumpen und Leitwerte der Rohrleitungen (abhängig von Rohrlänge und Querschnitt). Sind die genannten Parameter hinreichend genau bekannt, können die Druckverhältnisse an jeder Stelle des Systems berechnet werden. Allgemein gilt, dass der höchste Absolutdruck im Gaserzeuger herrscht, der niedrigste ist der Ansaugdruck direkt am Einlass der Vakuumpumpe(n).

Für jeden zu beschichtenden Flaschentyp wird ein spezielles Rezept erstellt, in dem unter anderem die Prozessgasmischung aus O₂, Ar, HMDSO und HMDSN definiert ist. Diese Mischung wird während des Betriebs der Maschine (mit dem gewählten Rezept) nicht verändert. Da sich auch die maßgeblichen Rohrleitungen nicht wesentlich verändern, ergeben sich sehr stabile Druckverhältnisse während des Beschichtungsbetriebs beziehungsweise in den Bereitschaftsphasen, wenn gerade keine Flaschen in der Vorrichtung beschichtet werden. Die Vorrichtung wird erst für die Beschichtung freigegeben, wenn ein stabiler Zustand im Vakuumsystem erreicht ist. Aufgrund der beschriebenen Stabilität des Systems (Druckgefälle) können die für ein gegebenes Rezept zu erwartenden Druckwerte im Normalzustand berechnet und gemessen werden.

Bei einer eingestellten Prozessgasmischung ergibt sich ein charakteristisches Druckgefälle, da sich die Rohrleitwerte und das Saugvermögen der Vorrichtung praktisch nicht verändern. Der Staudruck des Prozessgases stellt sich abhängig von der Leitungskonfiguration ein. Die notwendige Übergangszeit (Wartezeit) zwischen den Prozessschritten hängt von den jeweiligen beiden Werten des Staudrucks ab. Insbesondere wenn sich der Prozessgasstaudruck stark zwischen zwei Prozessschritten unterscheidet kann eine längere Gasaustauschphase notwendig werden. Dies kann sogar dazu führen, dass der Ausstoß an Flaschen gedrosselt werden muss um die notwendigen Beschichtungszeiten für alle Beschichtungsprozesse abbilden zu können.

Aus der WO 03/100125 A1 ist es bereits bekannt, eine Mehrzahl von Plasmakammern auf einem rotierenden Rad anzuordnen. Hierdurch wird eine hohe Produktionsrate von Behältern je Zeiteinheit unterstützt.

Eine Aufgabe der vorliegenden Erfindung besteht darin, eine Vorrichtung und ein Verfahren zur Plasmabehandlung von Behältern zu schaffen, bei der die Gasaustauschphase verkürzt wird.

Gelöst wird diese Aufgabe für die gattungsgemäße Vorrichtung und für das gattungsgemäße Verfahren durch die kennzeichnenden Merkmale des jeweiligen unabhängigen Anspruchs. Vorteilhafte Weiterbildungen der erfindungsgemäßen Vorrichtung und des erfindungsgemäßen Verfahrens sind in den abhängigen Ansprüchen genannt.

Dadurch, dass bei der Erfindung vorgesehen ist, dass in mindestens einer der Prozessgasleitungen und idealerweise in jeder Prozessgasleitung auf der der Plasmakammer abgewandten Seite des jeweiligen Prozessgasventils jeweils in einem separat festlegbaren Pufferabstand zum Prozessgasventil eine Drossel angeordnet ist, ist in dem Raum zwischen Prozessgasventil und Drossel ein Puffervolumen an Prozessgas vorhanden. Dies führt dazu, dass beim Öffnen des Prozessgasventils für einen neuen Beschichtungsvorgang das Puffervolumen an Prozessgas eine Beschleunigung des Prozessgas-Wechsels in der gemeinsamen zentralen Prozessgasleitung - bei genügend großem Puffervolumen sogar auch im zu behandelnden Behälter - eintritt.

Vorteilhafterweise kann die Drossel eine Lochblende sein, deren Lochdurchmesser bevorzugt 0,1 bis 10 mm beträgt. Solche Drosseln sind erprobt und erfüllen ihre Aufgabe sehr zuverlässig.

Vorteilhafterweise kann vor jedem Prozessgasventil der jeweilige Staudruck des Prozessgases 1-50 mbar, bevorzugt 5-30 mbar, betragen. Dadurch wird bei gleichzeitig guten Ergebnissen der Ex-Schutz gewährleistet.

Der Pufiferabstand ist so gewählt, dass das Puffervolumen des Prozessgases zwischen Prozessgasventil und Drossel 100-500 ml beträgt. Dies hat den Vorteil, dass mittels des Volumens von mindestens 100 ml, die gemeinsamen Gasleitung sicher gespült werden.

Vorteilhafterweise kann der Leitwert der Gasverteilung durch den Einbau der Drossein gegenüber dem Leitwert der Gasverteilung ohne Drossel um einen Faktor von 50 bis 2.000 reduziert werden. Hierdurch wird sicher der Staudruck eingestellt, was unter anderem auch eine Folge des Einbaus der Drossel ist.

Vorteilhafterweise sind genau drei Prozessgasleitungen vorhanden. Dadurch können die standardmäßig benötigten Prozessgase, wie beispielsweise Stickstoff, Sauerstoff und Argon, verwendet werden.

Vorteilhafterweise kann jedes Prozessgasventil Teil eines mindestens zwei Prozessgasventile, bevorzugt alle Prozessgasventile, integrierenden Mehrwegeventils sein. Durch die Integration mehrerer Ventile in einem einzigen Ventil kann Platz eingespart werden.

Dadurch, dass bei dem erfindungsgemäßen Verfahren ein Prozessgaspuffer vor einem dem jeweiligen Prozessgas zugeordneten Prozessgasventil erzeugt wird und somit eine Erhöhung des Staudrucks dieses Prozessgases vor dem zugeordneten Prozessgasventil stattfindet, kann der Prozessgaswechsel beschleunigt und eine Rückmischung der Prozessgase verringert werden, wodurch bessere Beschichtungen bei höherer Maschinengeschwindigkeit ermöglicht werden.

Vorteilhafterweise können mehrere unterschiedliche Prozessgase verwendet werden und ein Staudruck für jedes Prozessgas erreicht werden, der 1-50 mbar, bevorzugt 5-30 mbar, beträgt. Vorteilhafterweise kann der Leitwert der einzelnen Prozessgasleitungen um einen Faktor zwischen 50 und 2.000 abgesenkt werden. Es ergeben sich für beide Fälle die oben schon zur Vorrichtung ausgeführten Vorteile.

Vorteilhafterweise kann nach Öffnung des Prozessgasventils der Prozessgaspuffer mindestens die Leitung zwischen Prozessgasventil und Behälter spülen, bevorzugt zusätzlich auch noch den Behälter. Der Effekt besteht darin, dass ein größeres Gasvolumen in sehr kurzer Zeit gespült wird, so dass mehr Beschichtungszeit zur Verfügung steht und somit die Qualität der Beschichtung erhöht werden kann.

Vorteilhafterweise kann das erfindungsgemäße Verfahren auf einer erfindungsgemäßen Plasmabehandlungsvorrichtung ablaufen. Eine solche Vorrichtung kann durch nur geringfügige und leicht vorzunehmende Änderungen aus einer aus dem Stand der Technik bewährten Vorrichtung erreicht werden. Somit ergibt sich ein mit wenig Aufwand zu erreichender maximaler Erfolg.

Es versteht sich, dass die oben und nachfolgend erläuterten Merkmale und Ausführungsformen nicht nur in den jeweils angegebenen Kombinationen offenbart sind, sondern auch in Alleinstellung sowie in anderen Kombinationen zur Offenbarung gehörend anzusehen sind.

Nachfolgend wird die Erfindung anhand einer bevorzugten Ausführungsform mit Bezug auf die Zeichnungen näher erläutert. Die Zeichnungen zeigen:
- Figur 1: eine Prinzipskizze einer Mehrzahl von Plasmakammern, die auf einem rotierenden Plasmarad angeordnet sind und bei der das Plasmarad mit Eingabe- und Ausgaberädern gekoppelt ist,
- Figur 2: eine perspektivische Darstellung eines Plasmarades mit einer Vielzahl von Plasmakammern,
- Figur 3: ein schematisches Blockschaltbild einer bevorzugten Ausführungsform einer Beschichtungsstation der erfindungsgemäßen Vorrichtung zur Plasmabehandlung von Behältern und
- Figur 4: einen vergrößerten Ausschnitt aus dem schematisches Blockschaltbild der Figur 3 im Bereich der beiden exemplarisch dargestellten Plasmakammern samt Prozessgaszuführungen.

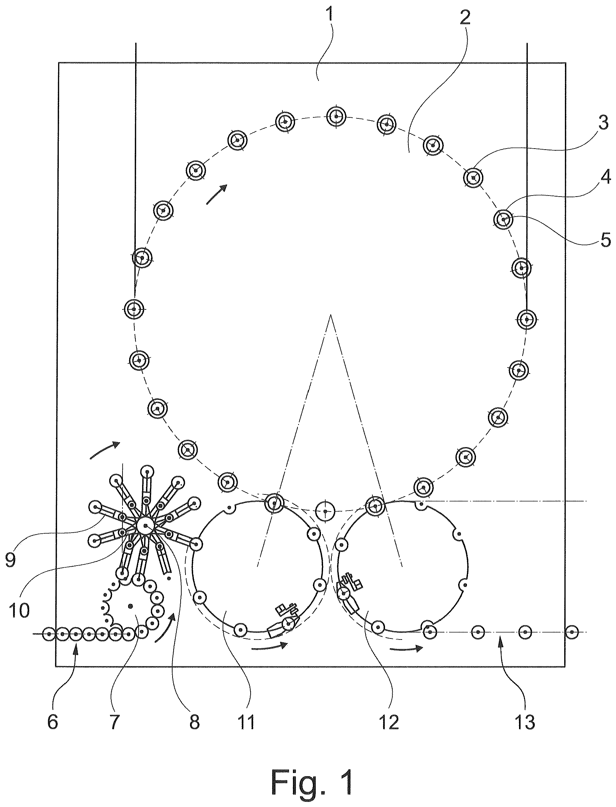

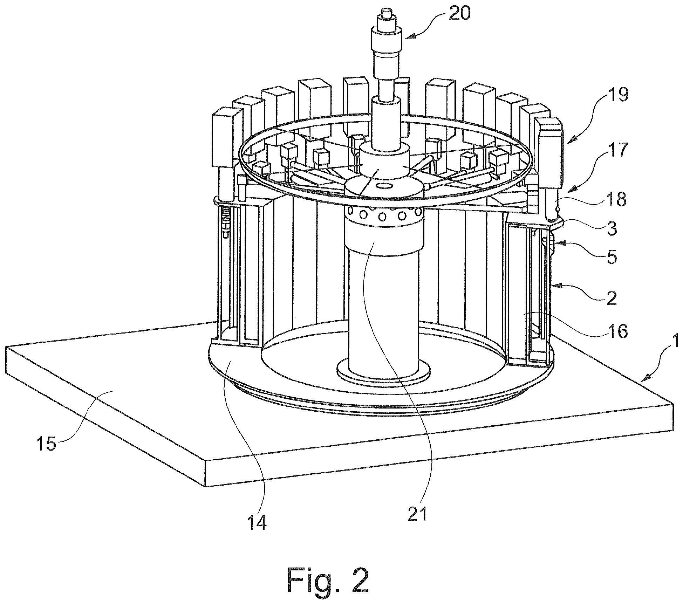

In den Figuren 1 und 2 wird ein rotierendes Plasmarad 2 zur Beschichtung von Behältern 5 gezeigt, wie es beispielsweise aus der oben genannten WO 2017/102280 A2 bekannt ist. Die Erfindung ist jedoch keineswegs auf ein rotierendes Plasmarad 2 beschränkt, sondern umfasst insbesondere alle rotierenden oder nicht rotierende Beschichtungsmaschinen, die einen oder mehr Prozessschritte mit festen Prozessgasmischungen und kontinuierlichem Prozessgas-Verbrauch haben. Sie ist auch nicht nur im Rahmen der Beschichtung der Innenflächen von Behältern 5 anwendbar, sondern insbesondere auch bei Füllern und Verpackungslösungen im Allgemeinen.

In Figur 1 ist mit dem Bezugszeichen 1 allgemein ein Plasmamodul bezeichnet, das mit dem rotierenden Plasmarad 2 versehen ist. Entlang eines Umfanges des Plasmarades 2 ist eine Mehrzahl von gleichartig aufgebauten Plasmastationen 3 angeordnet. Die Plasmastationen 3 sind mit Kammerinnenräumen 4 beziehungsweise Plasmakammern 17 zur Aufnahme von zu behandelnden Behältern 5 mit jeweils zumindest einem Behälterinnenraum versehen.

Die zu behandelnden Behälter 5 werden dem Plasmamodul 1 im Bereich einer Eingabe 6 zugeführt und über ein Vereinzelungsrad 7 an ein Übergaberad 8 weitergeleitet, das mit positionierbaren Tragarmen 9 ausgestattet ist. Die Tragarme 9 sind relativ zu einem Sockel 10 des Übergaberades 8 verschwenkbar angeordnet, so dass eine Abstandsveränderung der Behälter 5 relativ zueinander durchgeführt werden kann. Hierdurch erfolgt eine Übergabe der Behälter 5 vom Übergaberad 8 an ein Eingaberad 11 mit einem relativ zum Vereinzelungsrad 7 vergrößerten Abstand der Behälter 5 relativ zueinander. Das Eingaberad 11 übergibt die zu behandelnden Behälter 5 an das Plasmarad 2. Nach einer Durchführung der Behandlung werden die behandelten Behälter 5 von einem Ausgaberad 12 aus dem Bereich des Plasmarades 2 entfernt und in den Bereich einer Ausgabestrecke 13 überführt.

Figur 2 zeigt eine perspektivische Darstellung eines Plasmamoduls 1 mit teilweise aufgebautem Plasmarad 2. Die Plasmastationen 3 sind auf einem Tragring 14 angeordnet, der als Teil einer Drehverbindung ausgebildet und im Bereich eines Maschinensockels 15 gelagert ist. Die Plasmastationen 3 weisen jeweils einen Stationsrahmen 16 auf, der Plasmakammern 17 haltert. Die Plasmakammern 17 können zylinderförmige Kammerwandungen 18 sowie Mikrowellengeneratoren 19 aufweisen.

Anstatt der Ausführungsform gemäß Figur 2 können die Plasmastationen 3 auch jeweils mit zwei Behandlungsplätzen und zugehörigen Kammerinnenräumen 4 beziehungsweise Plasmakammern 17 ausgestattet sein. Hierdurch können jeweils zwei Behälter 5 gleichzeitig behandelt werden. Grundsätzlich ist es hierbei möglich, die Kammerinnenräume 4 vollständig voneinander getrennt auszubilden, grundsätzlich ist es aber auch möglich, in einem gemeinsamen Kammerinnenraum 4 lediglich Teilbereiche derart abzugrenzen, dass eine optimale Beschichtung aller Behälter 5 gewährleistet ist. Insbesondere ist hierbei daran gedacht, die Teilkammerinnenräume zumindest durch separate Mikrowelleneinkopplungen gegeneinander abzugrenzen.

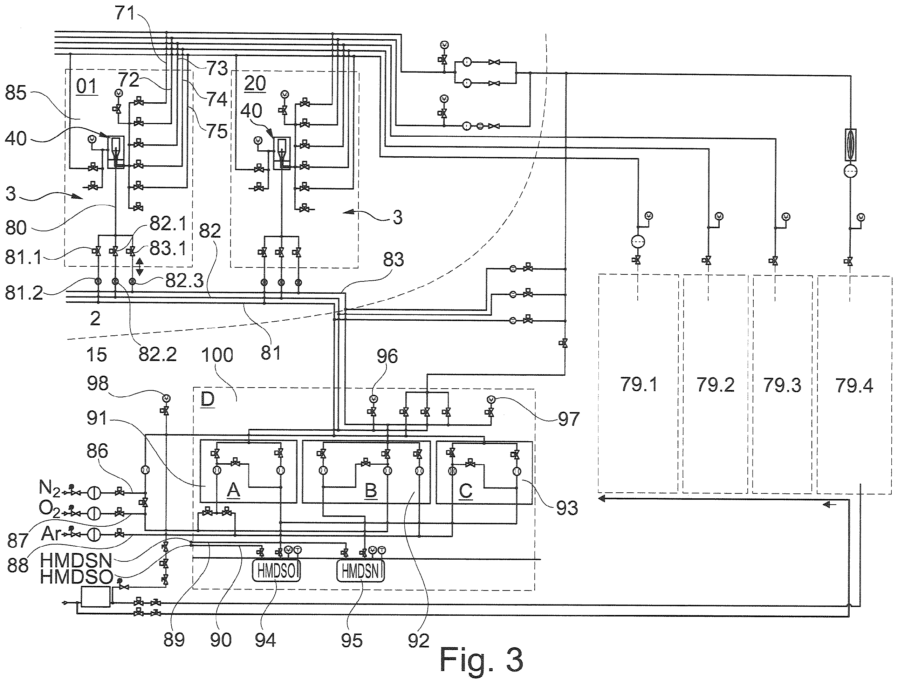

In einem Zentrum des Plasmarades 2 kann ein Drehverteiler 20 vorgesehen sein, über den die Plasmastationen 3 mit Betriebsmitteln, wie beispielsweise Prozessgas, sowie Energie versorgt werden. Insbesondere kann der Drehverteiler 20 mit einem zentralen Prozessgaserzeuger 100 mit einer Mehrzahl von Gasmischeinheiten 91, 92, 93 zusammenwirken, wie dies in Figur 3 dargestellt ist. Zur Betriebsmittelverteilung an dem Plasmarad 2 können insbesondere Ringleitungen 21 eingesetzt beziehungsweise angesetzt werden.

Die zu behandelnden Behälter 5 sind unterhalb der zylinderförmigen Kammerwandungen 18 dargestellt, wobei Unterteile der Plasmakammern 17 zur Vereinfachung jeweils nicht eingezeichnet sind.

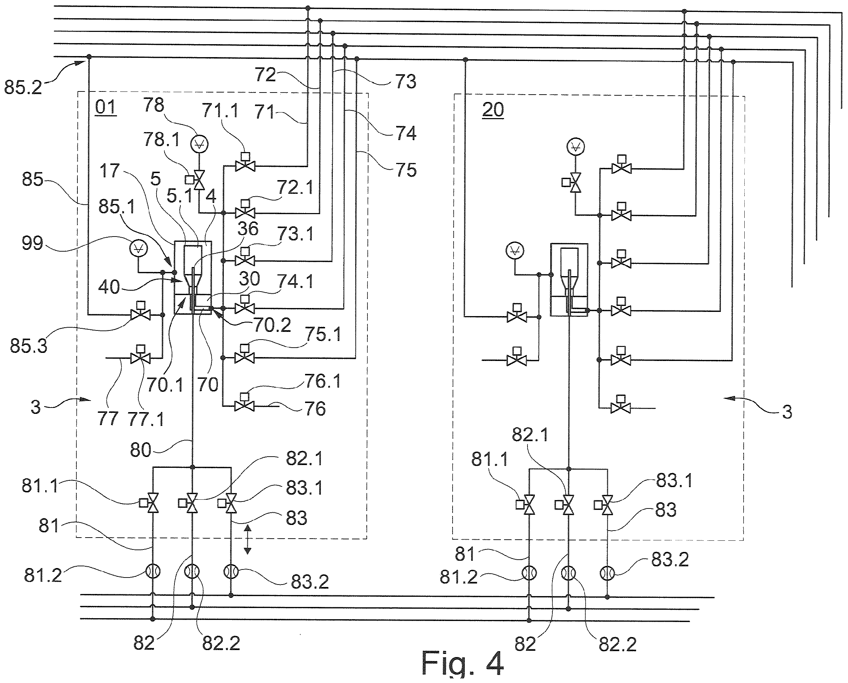

Die Figur 3 zeigt - insbesondere in Zusammenhang mit der vergrößerten Darstellung der Figur 4 - beispielhaft ein schematisches Blockschaltbild exemplarisch an zwei Plasmastationen 3 - die mit 01 und 20 bezeichnet sind - einer Beschichtungs- beziehungsweise Plasmastation 3, wie sie ein- oder mehrfach in einer Plasmakammer 17 angeordnet sein können, mit entsprechenden Zuleitungen, den drei Prozessgasleitungen 81 ... 83 samt darin angeordneter Drosseln 81.2 ... 83.2.

Alle Bauteile, die auf dem drehbaren Plasmarad 2 angeordnet sind, sind im linken oberen Teil der Figur 3 dargestellt und durch eine gestrichelte Linie von den Bauteilen getrennt, die in dem feststehenden Maschinensockel 15 - oder außerhalb desselben, aber ebenfalls feststehend - untergebracht sind.

In Figur 4, die einen Teil der Figur 3 - insbesondere die beiden Plasmakammern 3 mit Prozessgasleitungen 81 ... 83 samt darin angeordneter Ventileinrichtungen 81.1 ... 83.1 und Drosseln 81.2 ... 83.2 - darstellt, sind nur in der linken Plasmastation 3, die mit 01 bezeichnet ist, alle wesentlichen Bauteile mit Bezugszeichen versehen. Hingegen sind in der rechten Plasmastation 3, die mit 20 bezeichnet ist, aus Gründen der Übersichtlichkeit nur die Bauteile mit Bezugszeichen versehen, die für die Erfindung zur Abgrenzung gegenüber dem Stand der Technik ausschlaggebend sind.

In der Plasmakammer 17 wird im Kammerinnenraum 4 der Behälter 5 gas- und/oder luftdicht eingesetzt und positioniert. Vorliegend weist ein Kammersockel 30 dabei einen Vakuumkanal 70 auf. Der Vakuumkanal 70 mündet dabei mit seiner ersten Seite 70.1 in der Plasmakammer 17 beziehungsweise stellt je nach Stellung einer Gaslanze 36 zusätzlich auch eine gasdurchlässige Verbindung in den Behälterinnenraum 5.1 des Behälters 5 her. Insbesondere kann vorgesehen sein, dass in einem in den Behälterinnenraum 5.1 eingefahrenen Zustand der Gaslanze 36 der Behälterinnenraum 5.1 gegenüber dem Kammerinnenraum 4 isoliert, das heißt abgedichtet, ist, wohingegen in einem abgesenkten Zustand der Gaslanze 36 eine gasdurchlässige Verbindung zwischen dem Behälterinnenraum 5.1 des Behälters 5 und dem Kammerinnenraum 4 geschaffen wird.

Ferner kann an einer zweiten Seite 70.2 des Vakuumkanals 70 wenigstens eine erste bis fünfte Vakuumleitung 71 ... 75 sowie wenigstens eine Belüftungsleitung 76 angeschlossen sein, wobei insbesondere die Belüftungsleitung 76 über eine regel- und/oder steuerbare Ventileinrichtung 76.1 zu- beziehungsweise abschaltbar ausgebildet ist. Zudem kann auch jede der ersten bis fünften Vakuumleitungen 71 ... 75 jeweils zumindest eine regel- und/oder steuerbare Ventileinrichtung 71.1 ... 75.1 umfassen, wobei die Ventileinrichtungen 71.1 ... 76.1 über eine nicht näher dargestellte Maschinensteuerung der Vorrichtung zur Plasmabehandlung von Behältern 5 ansteuerbar ausgebildet sind.

An dem der zweiten Seite 70.2 des Vakuumkanals 70 abgewandten Ende stehen die erste bis fünfte Vakuumleitung 71 ... 75 vorzugsweise mit einer für alle Vakuumleitungen 71 ... 75 gemeinsamen Vakuumeinrichtung in fluiddichter Verbindung. Die Vakuumeinrichtung ist dabei insbesondere zur Erzeugung des in der Plasmakammer 17 sowie des Behälterinnenraums 5.1 während der Plasmabehandlung notwendigen Vakuums eingerichtet. Weiterhin ist die Vakuumeinrichtung dazu eingerichtet, an der ersten bis fünften Vakuumleitung 71...75 unterschiedliche Unterdrücke, also Unterdruckstufen je Vakuumleitung 71 ... 75, zu erzeugen. Hierzu sind die Vakuumleitungen 71 ... 75 mit Pumpstufen 79.1 ... 79.4 verbunden. Vorzugweise weist dabei die fünfte Vakuumleitung 75 einen gegenüber der ersten Vakuumleitung 71 größeren Unterdruck, also niedrigere Unterdruckstufe, auf. Insbesondere ist dabei vorgesehen, dass die Unterdruckstufen mit jeder Vakuumleitung 71 ... 75 weiter erniedrigt werden, derart, dass in der fünften Vakuumleitung 75 die niedrigste Unterdruckstufe vorherrscht. Alternativ ist es jedoch auch möglich, die einzelnen Vakuumleitungen 71 ... 75 an jeweils separate Vakuumeinrichtungen anzuschließen.

Insbesondere kann vorgesehen sein, dass über die erste bis fünfte Vakuumleitung 71 ... 75 die Plasmakammer 17 und/oder der Behälterinnenraum 5.1 auf unterschiedliche Unterdruckstufen abgesenkt werden. Beispielsweise kann hierfür angedacht sein, dass über die erste Vakuumleitung 71 bei geöffneter Ventileinrichtung 71.1 die Plasmakammer 17 einschließlich des Behälterinnenraums 5.1 auf eine erste Unterdruckstufe abgesenkt werden, während beispielsweise bei Öffnen der Ventileinrichtung 72.1 der zweiten Vakuumleitung 72 eine gegenüber der ersten Unterdruckstufe niedrigere Unterdruckstufe sowohl in der Plasmakammer 17 als auch in dem Behälterinnenraum 5.1 geschaffen wird. Weiterhin kann auch vorgesehen sein, dass beispielweise die fünfte Vakuumleitung 75 als Prozessvakuumleitung ausgebildet ist, die zur Aufrechterhaltung des Vakuums synchron zur Zuführung eines Prozessgases während der Plasmabehandlung geöffnet ist. Damit vermeidet die vorgesehene Prozessvakuumleitung einen Übertritt von abgesaugtem Prozessgas in die Versorgungskreise der weiteren Vakuumleitungen, beispielweise der ersten bis vierten Vakuumleitung 71 ... 74.

Auch kann der ersten bis fünften Vakuumleitung 71 ... 75 eine beispielweise als Druckmessröhre ausgebildete Druckmesseinrichtung 78 zugeordnet sein, die dazu eingerichtet ist, den über die erste bis fünfte Vakuumleitung 71 ... 75 erzeugten Unterdruck zu erfassen. Insbesondere kann der Druckmesseinrichtung 78 eine vorgeschaltete Ventileinrichtung 78.1 zugeordnet sein und die Druckmesseinrichtung 78 in einer Fluidverbindung der zweiten Vakuumleitung 72 zur zweiten Seite 70.2 des Vakuumkanals 70 angeordnet werden.

Zudem kann die Gaslanze 36 über eine beispielweise zentrale Prozessgasleitung 80 mit beispielweise einer ersten bis dritten Prozessgasleitung 81 ... 83 gekoppelt sein, über die jeweils unterschiedliche Prozessgaszusammensetzungen insbesondere dem Behälterinnenraum 5.1 mittels der Gaslanze 36 zuführbar sind. Eine jede der ersten bis dritten Prozessgasleitungen 81 ... 83 weist dabei erfindungsgemäß jeweils zumindest eine beispielweise über die zentrale Maschinensteuerung der Vorrichtung zur Plasmabehandlung von Behältern regel- und/oder steuerbare Prozessgasventile 81.1 ... 83.1 auf. Mithin kann auch die zentrale Prozessgasleitung 80 eine derartige steuer- und/oder regelbare Ventileinrichtung 80.1 umfassen.

Weiterhin kann auch eine sechste Vakuumleitung 85 mit einer ersten Seite 85.1 unmittelbar und insbesondere fluiddicht mit der Plasmakammer 17 verbunden sein beziehungsweise in diese einmünden, und mit einer zweiten Seite 85.2 unter Zwischenschaltung einer regel- und/oder steuerbaren Ventileinrichtung 85.3 über die fünfte Vakuumleitung 75 mit der zentralen Vakuumeinrichtung fluiddicht zusammenwirken. Der sechsten Vakuumleitung 85 ist einem Druckaufnehmer 99 zur Messung insbesondere des Unterdrucks innerhalb der Plasmakammer 17 zugeordnet. Aus dem damit gemessenen Druckwert ist die Prozessqualität in der Plasmastation 3, vor allem eine Veränderung der Prozessgasmischung ermittelbar. Ferner ist aus dem vom Druckaufnehmer 99 gemessenen Druckwert die Art einer Prozessbeeinflussung ermittelbar. Schließlich ist ein vom Druckaufnehmer 99 gemessener Druckwert mit weiteren Messwerten der Prozesserkennung zu Erstellung von Diagnosen zur Beschleunigung einer Fehlersuche zusammenführbar. Im Falle mehrerer Plasmastationen 3 sind durch Auswertung der Druckwerte der dort vorgesehenen Druckaufnehmer 99 globale und lokale Ursachen unterscheidbar und Fehler auf einen Ort einschränkbar. Ferner kann an der ersten Seite 85.1 der sechsten Vakuumleitung 85 eine Belüftungsleitung 77 angeschlossen sein, wobei diese insbesondere über eine regel- und/oder steuerbare Ventileinrichtung 77.1 zu- beziehungsweise abschaltbar ausgebildet ist.

Die beschriebene Ausführungsform unterscheidet sich insoweit nicht von der in der DE 2016 105 548 A1 gezeigten Ausführungsform, abgesehen von einer dort gezeigten Bypassleitung. Den erfinderischen Unterschied zu der dortigen Ausführungsform macht aber die im Folgenden nähere beschriebene Vorschaltung von Drosseln 81.2 ... 83.2 vor den steuerbaren Prozessgasventile 81.1 ... 83.1 in den Prozessgasleitungen 81 ... 83. Sowohl über die fünf Vakuumleitungen 71 ... 73 als auch die drei Prozessgasleitungen 81 ... 83 sind alle Plasmastationen - nicht nur die beiden dargestellten und mit 01 beziehungsweise bezeichneten 20 - über einen Ringschluss jeweils miteinander verbunden.

In der ersten Prozessgasleitung 81 ist stromaufwärts von der darin angeordneten Ventileinrichtung 81.1 in einem Abstand eine erste Drossel 81.2 angeordnet. Diese erste Drossel 81.2 kann als eine Lochblende - die beispielsweise aus einer Scheibe, die mit einer Bohrung versehen wird, gewonnen werden kann - ausgebildet sein. Der Durchmesser der Bohrung kann bevorzugt in einem Bereich von 0,1 bis 10 mm liegen. Der Abstand der ersten Drossel 81.2 von der Ventileinrichtung 81.1 hängt insbesondere davon ab, welchen Querschnitt die erste Prozessgasleitung 81 hat und welcher Staudruck vor der Ventileinrichtung 81.1 erzeugt werden soll. Das Volumen zwischen erster Drossel 81.2 und Ventileinrichtung 81.1 - das wie ein Druckreservoir fungiert - liegt in einem Beriech von 100 bis 500 ml, kann aber insbesondere wenn eine große Menge an Prozessgas zur Spülung des Behälters 5, der beschichtet werden soll, benötigt wird auch darüber liegen. Durch die erfindungsgemäße Ausgestaltung wird der Leitwert - der Kehrwert des Widerstands - der Gasverteilung abgesenkt, was zu einem höheren Staudruck vor der Ventileinrichtung 81.1 führt. Die Absenkung des Leitwerts kann bis zu einem Faktor 2.000 abgesenkt werden. Es können bevorzugt Staudrücke im Bereich von 5 bis 30 mbar und darüber erreicht werden, wobei er allerdings aus Gründen des Ex-Schutzes bevorzugt nicht über 50 mbar geht.

Für die beiden anderen Prozessgasleitungen 82 und 83 gilt dasselbe. Der Staudruck wird an das jeweilig höchste Niveau angepasst. Für ein beispielhaftes Rezept - Prozess 1: circa 10 mbar, Prozess 2: circa 22 mbar, Prozess 3: circa 13 mbar - verhält es sich in etwa so: Um einen sauberen Gaswechsel ohne Rückströmung von Prozess 2 zu 3 zu bekommen, sollte der Staudruck von Prozess 3 circa verdoppelt werden. Da die Drosseln 81.2 ... 83.2 aber nicht variabel sind, die Flüsse jedoch Rezeptparameter sind, sollten sie so gewählt werden, dass die kleinsten sinnvollen Flüsse für den jeweiligen Prozess immer einen größeren Staudruck erzeugen als der größte sinnvolle Fluss des vorhergehenden Prozesses. Dabei können die oben genannten Staudrücke entstehen. Bevorzugt wird, dass alle Prozessschritte entweder über einen annähernd gleichen Staudruck oder der Prozessfolge entsprechend über ansteigende (oder abfallende) Staudrücke verfügen.

Ein typischer Behandlungsvorgang an einer exemplarischen Plasmastation 3 ohne Betriebsstörung wird im Folgenden am Beispiel eines Beschichtungsvorgangs erläutert, wobei das Verfahren zur Plasmabehandlung von Behältern 5 an einer mehrere Plasmastationen 3 mit den jeweiligen Behandlungsplätzen 40 an einem Plasmarad 2 aufweisenden Vorrichtung zur Plasmabehandlung erfolgt.

Dabei wird zunächst der jeweilige Behälter 5 unter Verwendung eines Eingaberades 11 zum Plasmarad 2 transportiert und in einem hochgeschobenen Zustand einer hülsenartigen Kammerwandung der Behälter 5 in die entsprechende Plasmastation 3 eingesetzt. Nach einem Abschluss des Einsetzvorgangs wird die jeweilige Kammerwandung an dieser Plasmastation 3 in ihre abgedichtete Positionierung abgesenkt und zunächst gleichzeitig eine Evakuierung sowohl des Kammerinnenraumes 4 als auch des Behälterinnenraums 5.1 des Behälters 5 durchgeführt.

Nach einer ausreichenden Evakuierung des Kammerinnenraumes 4 wird die entsprechende Gaslanze 36 in den Behälterinnenraum 5.1 des Behälters 5 eingefahren und durch eine Verschiebung des Dichtelement eine Abdichtung des Behälterinnenraums 5.1 gegenüber dem Kammerinnenraum 4 durchgeführt. Es ist ebenfalls möglich, dass die Gaslanze 36 bereits synchron zur beginnenden Evakuierung des Kammerinnenraums 4 in den Behälter 5 hinein verfahren wird. Anschließend kann der Druck im Behälterinnenraum 5.1 noch weitergehend abgesenkt werden. Darüber hinaus ist auch daran gedacht, die Positionierbewegung der Gaslanze 36 wenigstens teilweise bereits parallel zur Positionierung der Kammerwandung durchzuführen. Nach Erreichen eines ausreichend tiefen Unterdrucks wird Prozessgas über die zentrale Prozessgasleitung 80 in den Behälterinnenraum 5.1 des Behälters 5 an der entsprechenden Plasmastation 3 eingeleitet und mit Hilfe eines Mikrowellengenerators das Plasma gezündet. Insbesondere kann vorgesehen sein, dass mit Hilfe des Plasmas sowohl ein Haftvermittler auf eine innere Oberfläche des Behälters 5 als auch die eigentliche Barriere- und Schutzschicht aus Siliziumoxiden abgeschieden wird.

Nach einer ausreichenden Prozessgaszuführung zündet der Mikrowellengenerator das Plasma im Behälterinnenraum 5.1 des Behälters 5. In diesem Zusammenhang kann vorgesehen sein, dass beispielsweise das erste Prozessgasventil 81.1 der ersten Prozessgasleitung 81 zu einem vorgebaren Zeitpunkt schließt, während das zweite Prozessgasventil 82.1 der zweiten Prozessgasleitung 82 zur Zuführung eines Prozessgases einer zweiten Zusammensetzung geöffnet wird. Zumindest zeitweise kann dabei auch die fünfte Ventileinrichtung 75.1 und/oder die sechste Ventileinrichtung 85.3 geöffnet sein, um einen ausreichend niedrigen Unterdruck insbesondere im Behälterinnenraum 5.1 und/oder der Prozesskammer 17 aufrecht zu halten. Hierbei erweist sich ein Druckniveau von ca. 0,3 mbar als zweckmäßig.

Nach Abschluss der Plasmabehandlung werden die Prozessgasventile 81.1 ... 83.1 der ersten bis dritten Prozessgasleitung 81 ... 83 sowie sämtliche zu diesem Zeitpunkt noch geöffneten Ventileinrichtungen 71.1 ... 75.1, 85.3 der ersten bis sechsten Vakuumleitung 71 ... 75, 85 geschlossen, während die Ventileinrichtung 76.1 der Belüftungsleitung 76 geöffnet und zumindest der Behälterinnenraum 5.1 des Behälters 5 nach der Plasmabehandlung an dem wenigsten einen Behandlungsplatz 40 der Plasmastation 3 wenigstens teilweise belüftet wird. Vorzugsweise wird der Behälterinnenraum 5.1 des Behälters 5 dabei bis auf Atmosphärendruck belüftet.

Synchron dazu kann die Gaslanze 36 aus dem Behälterinnenraum 5.1 abgesenkt werden. Nach einer ausreichenden Belüftung des Behälterinnenraums 5.1 und der Plasmakammer 17 bis auf vorzugsweise Atmosphärendruck, beziehungsweise Umgebungsdruck wird die geöffnete Ventileinrichtung 76.1 der Belüftungsleitung 76 geschlossen. Dabei beträgt die Belüftungszeit je Behälter 5 zwischen 0,1 und 0,4 Sekunden, vorzugsweise etwa 0,2 Sekunden. Nach Erreichen des Umgebungsdruckes innerhalb des Kammerinnenraums 4 wird die Kammerwandung wieder angehoben. Nachfolgend erfolgt eine Entnahme beziehungsweise Übergabe des beschichteten Behälters 5 an ein Ausgaberad 12.

Figur 3 zeigt ein schematisches Blockschaltbild einer Ausführungsform des Prozessgaserzeugers 100, der der Plasmastation 3 Prozessgase unterschiedlicher Zusammensetzung zuführt. Über eine Leitung 86 wird dem Prozessgaserzeuger 100 Stickstoff zugeführt. Über eine Leitung 87 wird dem Prozessgaserzeuger 100 Sauerstoff zugeführt. Über eine Leitung 88 wird dem Prozessgaserzeuger 100 Argon zugeführt. Über eine Leitung 89 wird dem Prozessgaserzeuger 100 HMDSN zugeführt und über eine Leitung 90 wird dem Prozessgaserzeuger 100 HMDSO zugeführt. In den Leitungen 86 ... 90 sind Ventile zur Dosierung beziehungsweise zum Sperren der jeweiligen Gaszuführung angeordnet. Der Prozessgaserzeuger 100, bei dem es sich um einen geheizten Bereich handelt, umfasst drei Gasmischeinheiten 91, 92 und 93 zur Bereitstellung von Prozessgasen unterschiedlicher Zusammensetzung und zwei Gaserwärmungszylinder 94 und 95. Der Gaserwärmungszylinder 94 wird mit dem HMDSO beschickt, das am Ausgang des Zylinders 94 mit einer Temperatur und einem Druck zur Verfügung steht, die für die Mischung der Gase in der Gasmischeinheit 91 und 93 geeignet sind, denen das erwärmte HMDSO über mit Sperrventilen bestückten Rohrleitungen zugeführt wird. Der Gaserwärmungszylinder 95 wird mit dem HDMSN beschickt, das am Ausgang des Zylinders 95 mit einer Temperatur und einem Druck zur Verfügung steht, die für die Mischung der Gase in der Gasmischeinheit 92 geeignet sind, der das erwärmte HMDSN über eine mit einem Sperrventil bestückte Rohrleitung zugeführt wird.

Zusätzlich zu dem HMDSO wird der Gasmischeinheit 91 über mit Sperrventilen versehene Rohrleitungen Sauerstoff und Argon, sowie gegebenenfalls Stickstoff, zugeführt. Zusätzlich zu dem HMDSO wird der Gasmischeinheit 93 über eine Rohrleitung Argon zugeführt. Zusätzlich zu dem HMDSN wird der Gasmischeinheit 92 über Rohrleitungen Sauerstoff und Argon, sowie gegebenenfalls Stickstoff, zugeführt. Die Gasmischeinheiten 91, 92 und 93 enthalten jeweils mehrere Massendurchflussregler (MFC) und Ventile zur gezielten Mischung der ihnen zugeführten Gase. Die Gasmischungen stehen an den Auslässen der Gasmischeinheiten 91, 92 und 93 als Prozessgase zur Verfügung. Im Einzelnen handelt es sich bei dem am Ausgang der Gasmischeinheit 91 bereitgestehenden Prozessgas um einen gasförmigen Haftvermittler, bei dem am Ausgang der Gasmischeinheit 92 bereitstehenden Prozessgas um ein Barrieregas und bei dem am Ausgang der Gasmischeinheit 93 bereitstehenden Prozessgas um ein Topcoat-Gas. Der Druck der jeweiligen Prozessgase wird in den Prozessgasleitungen 81, 82 und 83 durch Druckaufnehmer 96, 97 und 98 gemessen.

Das beschriebene Verfahren unterscheidet sich insoweit nicht von dem in der DE 2016 105 548 A1 gezeigten Verfahren - abgesehen von den dortigen Ausführungen zu der Nutzung der Bypassleitung, wenn eine der Prozessgasleitungen defekt sein sollte. Den erfinderischen Unterschied zu der dortigen Ausführungsform macht aber die im Folgenden nähere beschriebene Vorschaltung von Drosseln 81.2 ... 83.2 vor den steuerbaren Prozessgasventilen 81.1 ... 83.1 in den Prozessgasleitungen 81 ... 83.

Aufgrund des Gasreservoirs, das zwischen der jeweiligen Drossel 81.2 ... 83.2 und der zugehörigen Ventileinrichtung 81.1... 83.1 in den jeweiligen Prozessgasleitungen 81 ... 83 vorhanden ist und welches bei einem hohen Druck im Bereich zwischen 5 und 50 mbar vorliegt, entweicht beim Öffnen der jeweiligen Ventileinrichtung 81.1... 83.1, bedingt durch deren geringen Leitwert, das Prozessgas des jeweiligen Druckreservoirs schlagartig. Die in den jeweiligen Prozessgasleitungen 81 ... 83 dabei entstehenden Staudrücke müssen nur kleiner sein als der Dampfdruck des jeweiligen Precursors - aufgrund der Ex-Schutz Regularien ist eine Begrenzung auf 50 mbar sinnvoll. Das Prozessgas wird beim Öffnen der jeweiligen Ventileinrichtung 81.1... 83.1 aus dem Bereich hinter der jeweiligen Ventileinrichtung 81.1... 83.1 - also im Wesentlichen aus der zentralen Prozessgasleitung 80 zwischen den Ventileinrichtungen 81.1... 83.1 und dem Behälter 5 - vertrieben. Dort stellt sich während der Öffnung einer der Ventileinrichtungen 81.1... 83.1 ebenfalls der vorherrschende Staudruck ein. So könnte es aufgrund des vom vorangehenden Prozess noch vorhandenen Prozessgas aus diesem Bereich auch zu Rückströmungen kommen, sollte der Druck hinter der als nächstes zu öffnenden Ventileinrichtung 81.1... 83.1 geringer sein. Je nach Größe des vorhanden Puffervolumens im Druckreservoir und der vorhandenen Größe der Blendenöffnung in der jeweiligen Drossel 81.2 ... 83.2 kann eventuell sogar auch der Behälter 5 noch schneller gespült werden.

Aufgrund dieses erfindungsgemäßen Verfahrens wird der Prozessgaswechsel beschleunigt und es eine Rückmischung der Prozessgase verringert. Dies ermöglicht eine bessere Beschichtung der Behälter 5 bei gleichzeitig höherer Maschinengeschwindigkeit.

Zusammenfassend kann festgehalten werden, dass durch das Einsetzen der Drosseln 81.2 ... 83.2 vor den Ventileinrichtungen 81.1 ... 83.1 in den Prozessgasleitungen 81 ... 83 eine Harmonisierung der Prozessgas-Staudrücke erreicht wird, was zu einer Beschleunigung des Prozessgas-Wechsels führt. Dies führt insbesondere in Fällen, in denen sich der Prozessgas-Staudruck stark zwischen zwei Prozessschritten unterscheidet dazu, dass eine Verkürzung der Gasaustauschphase erreicht wird. Dadurch wird vermieden, dass der Ausstoß an zu beschichtenden Behältern 5 gedrosselt werden muss, um die notwendigen Beschichtungszeiten für alle Beschichtungsprozesse abbilden zu können. Besonders vorteilhaft an der Erfindung ist es, dass die aus dem Stand der Technik bekannten Beschichtungsvorrichtungen nach einer sehr einfach vorzunehmenden Manipulation weiterhin verwendet werden können.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrunde liegende Erfindungsgedanke verlassen wird, der durch die Ansprüche definiert wird.

### Bezugszeichenliste

- 1: Plasmamodul
- 2: Plasmarad
- 3: Plasmastation
- 4: Kammerinnenraum
- 5: Behälter
- 5.1: Behälterinnenraum
- 6: Eingabe
- 7: Vereinzelungsrad
- 8: Übergaberad
- 9: Tragarm
- 10: Sockel
- 11: Eingaberad
- 12: Ausgaberad
- 13: Ausgabestrecke
- 14: Tragring
- 15: Maschinensockel
- 16: Stationsrahmen
- 17: Plasmakammer
- 18: Kammerwandung
- 19: Mikrowellengenerator
- 20: Drehverteiler
- 21: Ringleitung
- 30: Kammersockel
- 36: Gaslanze
- 40: Behandlungsplatz
- 70: Vakuumkanal
- 70.1: erste Seite
- 70.2: zweite Seite
- 71: erste Vakuumleitung
- 71.1: Ventileinrichtung
- 72: zweite Vakuumleitung
- 72.1: Ventileinrichtung
- 73: dritte Vakuumleitung
- 73.1: Ventileinrichtung
- 74: vierte Vakuumleitung
- 74.1: Ventileinrichtung
- 75: fünfte Vakuumleitung
- 75.1: Ventileinrichtung
- 76: Belüftungsleitung
- 76.1: Ventileinrichtung
- 77: Belüftungsleitung
- 77.1: Ventileinrichtung
- 78: Druckmesseinrichtung
- 78.1: Ventileinrichtung
- 79.1: Pumpstufe
- 79.2: Pumpstufe
- 79.3: Pumpstufe
- 79.4: Pumpstufe
- 80: zentrale Prozessgasleitung
- 80.1: Ventileinrichtung
- 81: erste Prozessgasleitung
- 81.1: Ventileinrichtung
- 81.2: Drossel
- 82: zweite Prozessgasleitung
- 82.1: Ventileinrichtung
- 82.2: Drossel
- 83: dritte Prozessgasleitung
- 83.1: Ventileinrichtung
- 83.2: Drossel
- 85: sechste Vakuumleitung
- 85.1: erste Seite
- 85.2: zweite Seite
- 85.3: Ventileinrichtung
- 86: Leitung
- 87: Leitung
- 88: Leitung
- 89: Leitung
- 90: Leitung
- 91: Gasmischeinheit
- 92: Gasmischeinheit
- 93: Gasmischeinheit
- 94: Gaserwärmungszylinder
- 95: Gaserwärmungszylinder
- 96: Druckaufnehmer
- 97: Druckaufnehmer
- 98: Druckaufnehmer
- 99: Druckaufnehmer
- 100: Prozessgaserzeuger

## Patentansprüche

1. Vorrichtung zur Plasmabehandlung von Behältern (5), aufweisend einen Prozessgaserzeuger (100) zum Erzeugen einer Prozessgasmischung und zumindest eine Plasmastationen (3), die mindestens eine Plasmakammer (17) mit einem Behandlungsplatz (40) umfasst, in welcher mindestens ein Behälter (5) mit einem Behälterinnenraum (5.1) an dem Behandlungsplatz (40) einsetzbar und positionierbar ist, wobei die jeweilige Plasmakammer (17) zumindest teilweise evakuierbar ausgebildet ist, um ein vom Prozessgaserzeuger (100) bereitgestelltes Prozessgas durch den Behälter (5) zu saugen, das dessen Innenraum mittels Plasmabehandlung mit einer Innenbeschichtung versieht, wobei eine Mehrzahl von verschiedenen Prozessgasen vorhanden ist und jedes Prozessgas über eine eigene Prozessgasleitung (81, 82, 83) über ein darin angeordnetes Prozessgasventil (81.1, 82.1, 83.1) mit der Plasmakammer (17) verbunden ist, wobei in mindestens einer Prozessgasleitung (81, 82, 83) auf der der Plasmakammer (17) abgewandten Seite des zugeordneten Prozessgasventils (81.1, 82.1, 83.1) in einem separat festlegbaren Pufferabstand zum Prozessgasventil (81.1, 82.1, 83.1) eine Drossel (81.2, 82.2, 83.2) angeordnet ist, **dadurch gekennzeichnet, dass** der Pufferabstand so gewählt ist, dass das Puffervolumen des Prozessgases zwischen Prozessgasventil (81.1, 82.1, 83.1) und Drossel (81.2, 82.2, 83.2) 100 - 500 ml beträgt.

2. Vorrichtung nach Anspruch 1, wobei in jeder Prozessgasleitung (81, 82, 83) auf der der Plasmakammer (17) abgewandten Seite des jeweiligen Prozessgasventils (81.1, 82.1, 83.1) jeweils in einem separat festlegbaren Pufferabstand zum Prozessgasventil (81.1, 82.1, 83.1) eine Drossel (81.2, 82.2, 83.2) angeordnet ist.

3. Vorrichtung nach einem der Ansprüche 1 oder 2, wobei die Drossel (81.2, 82.2, 83.2) eine Lochblende ist, deren Lochdurchmesser bevorzugt 0,1 bis 10 mm beträgt.

4. Vorrichtung nach einem der Ansprüche 1 bis 3, wobei vor jedem Prozessgasventil (81.1, 82.1, 83.1) der jeweilige Staudruck des Prozessgases 1-50 mbar, bevorzugt 5-30 mbar, beträgt.

5. Vorrichtung nach einem der Ansprüche 1 bis 4, wobei der Leitwert der Gasverteilung durch den Einbau der Drosseln (81.2, 82.2, 83.2) gegenüber dem Leitwert der Gasverteilung ohne Drossel um einen Faktor von 50 bis 2.000 reduziert ist.

6. Vorrichtung nach einem der Ansprüche 1 bis 5, wobei genau drei Prozessgasleitungen (81, 82, 83) vorhanden sind.

7. Vorrichtung nach einem der Ansprüche 1 bis 6, wobei jedes Prozessgasventil (81.1, 82.1, 83.1) Teil eines mindestens zwei Prozessgasventile (81.1, 82.1, 15 83.1), bevorzugt alle Prozessgasventile (81.1, 82.1, 83.1), integrierenden Mehrwegeventils ist.

8. Verfahren zur Plasmabehandlung von Behältern (5) in einer Plasmabehandlungsvorrichtung, welches folgende Verfahrensschritte umfasst:
- Erzeugen einer Prozessgasmischung durch einen Prozessgaserzeuger (100),
- Einsetzen und Positionieren eines Behälters (5) mit einem Behälterinnenraum (5.1) an einem Behandlungsplatz (40) zumindest einer Plasmakammer (17) einer Plasmastation (3),
- zumindest teilweises Evakuieren der jeweiligen Plasmakammer (17), um das vom Prozessgaserzeuger (100) bereitgestellte Prozessgas durch den Behälter (5) zu saugen, das dabei dessen Innenraum mittels Plasmabehandlung mit einer Innenbeschichtung versieht,
**dadurch gekennzeichnet, dass**
- ein Prozessgaspuffer vor einem dem jeweiligen Prozessgas zugeordneten Prozessgasventil (81.1, 82.1, 83.1) erzeugt wird und somit eine Erhöhung des Staudrucks dieses Prozessgases vor dem zugeordneten Prozessgasventil (81.1, 82.1, 83.1) stattfindet, wobei der Prozessgaspuffer erzeugt wird, indem in mindestens einer Prozessgasleitung (81, 82, 83) auf der der Plasmakammer (17) abgewandten Seite des zugeordneten Prozessgasventils (81.1, 82.1, 83.1) in einem separat festlegbaren Pufferabstand zum Prozessgasventil (81.1, 82.1, 83.1) eine Drossel (81.2, 82.2, 83.2) angeordnet wird, wobei der Pufferabstand so gewählt ist, dass das Puffervolumen des Prozessgases zwischen Prozessgasventil (81.1, 82.1, 83.1) und Drossel (81.2, 82.2, 83.2) 100-500 ml beträgt.

9. Verfahren nach Anspruch 8, wobei mehrere unterschiedliche Prozessgase verwendet werden und ein Staudruck für jedes Prozessgas erreicht wird, der 1-50 5 mbar, bevorzugt 5-30 mbar, beträgt.

10. Verfahren nach einem der Ansprüche 8 oder 9, wobei der Leitwert der einzelnen Prozessgasleitungen um einen Faktor zwischen 50 und 2.000 abgesenkt wird.

11. Verfahren nach einem der Ansprüche 8 bis 10, wobei nach Öffnung des Prozessgasventils (81.1, 82.1, 83.1) der Prozessgaspuffer mindestens die Leitung zwischen Prozessgasventil (81.1, 82.1, 83.1) und Behälter (5), bevorzugt zusätzlich auch noch den Behälter (5), spült. 15

12. Verfahren nach einem der Ansprüche 8 bis 11, wobei die Plasmabehandlungsvorrichtung eine Vorrichtung nach einem der Ansprüche 1 bis 7 ist.

## Claims

1. Device for plasma treatment of containers (5), comprising a process-gas generator (100) for generating a process-gas mixture and at least one plasma station (3) comprising at least one plasma chamber (17) with a treatment space (40), in which at least one container (5) with a container interior space (5.1) can be used and positioned at the treatment space (40), wherein the respective plasma chamber (17) is at least partially designed to be evacuable in order to suck a process gas provided by the process-gas generator (100) through the container (5), which provides its interior space with an internal coating by means of plasma treatment, wherein a plurality of different process gases are present and each process gas is connected to the plasma chamber (17) via its own process-gas line (81, 82, 83) via a process-gas valve (81.1, 82.1, 83.1) located therein, wherein, in at least one process-gas line (81, 82, 83) on the side of the assigned process-gas valve (81.1, 82.1, 83.1) facing away from the plasma chamber (17) at a separately definable buffer distance to the process-gas valve (81.1, 82.1, 83.1), a throttle (81.2, 82.2, 83.2) is arranged, **characterized in that** the buffer distance is chosen in such a way that the buffer volume of the process gas between the process-gas valve (81.1, 82.1, 83.1) and the throttle (81.2, 82.2, 83.2) is 100 - 500 ml.

2. The device according to Claim 1, wherein, in each process-gas line (81, 82, 83) on the side of the respective process-gas valve (81.1, 82.1, 83.1) facing away from the plasma chamber (17), a throttle (81.2, 82.2, 83.2) is arranged at a separately definable buffer distance to the process-gas valve (81.1, 82.1, 83.1).

3. The device according to any one of the Claims 1 or 2, wherein the throttle (81.2, 82.2, 83.2) is a pinhole aperture, the hole diameter of which is preferably 0.1 to 10 mm.

4. The device according to any one of the Claims 1 to 3, wherein upstream to each process-gas valve (81.1, 82.1, 83.1), the respective dynamic pressure of the process gas is 1-50 mbar, preferably 5-30 mbar.

5. The device according to any one of the Claims 1 to 4, wherein the conductivity value of the gas distribution is reduced by a factor of 50 to 2,000 by the installation of the throttles (81.2, 82.2, 83.2) with relation to the conductivity value of the gas distribution without throttle.

6. Device according to any one of the Claims 1 to 5, wherein exactly three process-gas lines (81, 82, 83) are present.

7. The device according to any one of the Claims 1 to 6, wherein each process-gas valve (81.1, 82.1, 83.1) is part of a multi-port valve integrating at least two process-gas valves (81.1, 82.1, 15 83.1), preferably all process-gas valves (81.1, 82.1, 83.1).

8. Method for plasma treatment of containers (5) in a plasma-treatment device, comprising the following method steps:
- generating a process-gas mixture by a process-gas generator (100),
- insertion and positioning of a container (5) with a container interior space (5.1) at a treatment space (40) at least one plasma chamber (17) of a plasma station (3),
- at least partial evacuation of the respective plasma chamber (17) in order to suck the process gas provided by the process-gas generator (100) through the container (5), which thereby provides its interior space with an internal coating by means of plasma treatment,
**characterized in that**
- a process-gas buffer is generated upstream of a process-gas valve assigned to the respective process gas (81.1, 82.1, 83.1) and thus an increase in the dynamic pressure of this process gas occurs upstream to the assigned process-gas valve (81.1, 82.1, 83.1), wherein the process-gas buffer is generated by arranging a throttle (81.2, 82.2, 83.2) at a separately definable buffer distance from the process-gas valve (81.1, 82.1, 83.1) in at least one process-gas line (81, 82, 83) on the side of the assigned process-gas valve (81.1, 82.1, 83.1) facing away from the plasma chamber (17), wherein the buffer distance is chosen so that the buffer volume of the process gas between the process-gas valve (81.1, 82.1, 83.1) and the throttle (81.2, 82.2, 83.2) is 100-500 ml.

9. The method according to Claim 8, wherein a plurality of different process gases are used, and a dynamic pressure is achieved for each process gas which is 1-50 5 mbar, preferably 5-30 mbar.

10. The method according to any one of the Claims 8 or 9, wherein the conductivity value of the individual process-gas lines is lowered by a factor between 50 and 2,000.

11. The method according to any one of the Claims 8 to 10, wherein, after opening the process-gas valve (81.1, 82.1, 83.1), the process-gas buffer flushes at least the line between the process-gas valve (81.1, 82.1, 83.1) and the container (5), preferably also the container (5).

12. The method according to any one of the Claims 8 to 11, wherein the plasma-treatment device is an device according to any one of the Claims 1 to 7.

## Revendications

1. Dispositif de traitement au plasma de récipients (5), présentant un générateur de gaz de procédé (100) pour la production d'un mélange de gaz de procédé et au moins une station de plasma (3) comprenant au moins une chambre à plasma (17) avec un emplacement de traitement (40) dans laquelle station au moins un récipient (5) avec un espace intérieur (5.1) peut être introduit et positionné dans l'emplacement de traitement (40), la chambre à plasma (17) respective étant conçue pour pouvoir, en partie au moins, être évacuée pour aspirer par le récipient (5) le gaz de procédé fourni par le générateur de gaz de procédé (100), ce gaz ayant doté l'espace intérieur du récipient d'un revêtement déposé par traitement au plasma, le dispositif présentant une pluralité de gaz de procédé différents et chaque gaz de procédé étant conduit vers la chambre à plasma (17) par sa propre conduite de gaz de procédé (81, 82, 83) et par l'intermédiaire d'une soupape à gaz de procédé (81.1, 82.1, 83.1) agencée dans la conduite, un organe d'étranglement (81.2, 82.2, 83.2) étant agencé dans au moins une conduite de gaz de procédé (81, 82, 83) du côté de la soupape à gaz de procédé (81.1, 82.1, 83.1) correspondante opposé à la chambre à plasma (17) à une distance tampon de la soupape à gaz de procédé (81.1, 82.1, 83.1), cette distance étant réglable séparément, **caractérisé en ce que** la distance tampon étant choisie telle que le volume tampon de gaz de procédé entre la soupape à gaz de procédé (81.1, 82.1, 83.1) et l'organe d'étranglement (81.2, 82.2, 83.2) est de 100 à 500 ml.

2. Dispositif selon la revendication 1, un organe d'étranglement (81.2, 82.2, 83.2) étant agencé dans chaque conduite de gaz de procédé (81, 82, 83) du côté de la soupape à gaz de procédé (81.1, 82.1, 83.1) correspondante opposé à la chambre à plasma (17) à une distance tampon de la soupape à gaz de procédé (81.1, 82.1, 83.1), cette distance étant respectivement réglable séparément.

3. Dispositif selon l'une des revendications 1 ou 2, l'organe d'étranglement (81.2, 82.2, 83.2) étant un diaphragme à trou dont le trou a de préférence un diamètre de 0,1 à 10 mm.

4. Dispositif selon l'une des revendications 1 à 3, la pression dynamique du gaz de procédé en amont de chaque soupape à gaz de procédé (81.1, 82.1, 83.1) étant de 1 à 50 mbar, de préférence de 5 à 30 mbar :

5. Dispositif selon l'une des revendications 1 à 4, la conductance de la distribution de gaz étant réduite du fait de la pose des organes d'étranglement (81.2, 82.2, 83.2) d'un facteur de 50 à 2000 par rapport à la conductance d'une distribution de gaz sans organes d'étranglement.

6. Dispositif selon l'une des revendications 1 à 5 disposant d'exactement trois conduites de gaz de procédé (81, 82, 83).

7. Dispositif selon l'une des revendications 1 à 6, chaque soupape à gaz de procédé (81.1, 82.1, 83.1) faisant partie d'une vanne multivoies intégrant au moins deux soupapes à gaz de procédé (81.1, 82.1, 15 83.1) mais de préférence toutes les soupapes à gaz de procédé (81.1, 82.1, 83.1).

8. Procédé de traitement au plasma de récipients (5) dans un dispositif de traitement au plasma comprenant les étapes de procédé suivantes :
- production d'un mélange de gaz de procédé par un générateur de gaz de procédé (100) ;
- mise en place et positionnement d'un récipient (5) avec un espace intérieur (5.1) dans un emplacement de traitement (40) d'au moins une chambre à plasma (17) d'une station de plasma (3);
- évacuation au moins partielle de la chambre à plasma (17) respective pour aspirer le gaz de procédé fourni par le générateur de gaz de procédé (100) par le récipient (5) sur la paroi intérieure de l'espace intérieur duquel le gaz dépose alors un revêtement par traitement au plasma,
**caractérisé en ce que**
- un tampon de gaz de procédé est produit en amont d'une soupape à gaz de procédé (81.1, 82.1, 83.1) associée au gaz de procédé respectif, ce qui entraîne une augmentation de la pression de stagnation de ce gaz de procédé en amont de la soupape à gaz de procédé (81.1, 82.1, 83.1) qui lui est associée, le tampon de gaz de procédé étant produit en agençant un organe d'étranglement (81.2, 82.2, 83.2) dans au moins une conduite de gaz de procédé (81, 82, 83) du côté de la soupape à gaz de procédé (81.1, 82.1, 83.1) correspondante opposé à la chambre à plasma (17) à une distance tampon, réglable séparément, de la soupape à gaz de procédé (81.1, 82.1, 83.1), cette distance étant choisie telle que le volume tampon de gaz de procédé entre la soupape à gaz de procédé (81.1, 82.1, 83.1) et l'organe d'étranglement (81.2, 82.2, 83.2) est de 100 à 500 ml.

9. Procédé selon la revendication 8, mettant en oeuvre plusieurs gaz de procédé différents, une pression de stagnation de 1 à 50 mbar, de préférence de 5 à 30 mbar, étant obtenue pour chaque gaz de procédé.

10. Procédé selon l'une des revendications 8 ou 9, la conductance des différentes conduites de gaz de procédé étant réduite d'un facteur compris entre 50 et 2000.

11. Procédé selon l'une des revendications 8 à 10, le tampon de gaz de procédé rinçant, après ouverture de la soupape à gaz de procédé (81.1, 82.1, 83.1), au moins la conduite entre la soupape à gaz de procédé (81.1, 82.1, 83.1) et le récipient (5), et de préférence également le récipient (5).

12. Procédé selon l'une des revendications 8 à 11, le dispositif de traitement au plasma étant un dispositif selon l'une des revendications 1 à 7.
